# EUROPEAN PATENT APPLICATION

(11) **EP 4 174 136 A1**
(43) Date of publication of application: **03.05.2023**
(21) Application number: 21831693.3
(22) Date of filing: 21.06.2021
(51) Int. Cl.: C08L 83/07, C08K 9/10, C08L 83/05, H01L 23/29, H01L 23/31

(54) **CURABLE ORGANOPOLYSILOXANE COMPOSITION AND USE THEREFOR**

(30) Priority: 30.06.2020 JP 2020112949
(71) Applicant: Dow Toray Co., Ltd., Tokyo 140-8617 (JP)
(72) Inventor: TANAKA, Shouko, Ichihara-shi Chiba 299-0108 (JP); TODA, Nohno, Ichihara-shi Chiba 299-0108 (JP); SUTOH, Manabu, Ichihara-shi Chiba 299-0108 (JP)
(74) Representative: Murgitroyd & Company
(86) International application number: PCT/JP2021/023399
(87) International publication number: WO 2022/004463

(57) **Abstract**

[Problem]

Provided is a curable organopolysiloxane composition having favorable curing properties, maintaining a favorable pot life even as a single component composition and showing sharp and rapid curing reactivity triggered by ultraviolet light or other high energy beam irradiation and heating, and in which curing defect problems are less likely to occur even in light shielded portions where irradiation with a high energy beam such or the like is difficult.

[Resolution Means]

A curable organopolysiloxane composition containing (A) an organopolysiloxane having a monovalent hydrocarbon group containing an aliphatic unsaturated bond, (B) an organohydrogenpolysiloxane, (C) a first hydrosilylation catalyst that exhibits activity by irradiating with a high energy beam, and (D) a second hydrosilylation catalyst microencapsulated by a thermoplastic resin with a softening point within a temperature range of 50 to 200°C, wherein a hydrosilylation reaction inhibitor (E) is preferably substantially not required; and a method of forming an organopolysiloxane cured product using same.

## Description

### TECHNICAL FIELD

The present invention relates to: a curable organopolysiloxane composition containing two different types of hydrosilylation reaction catalysts; a method of manufacturing an organopolysiloxane cured product cured by a hydrosilylation reaction; a method of manufacturing a semiconductor component or display device using the method; and the like.

### BACKGROUND ART

The hydrosilylation reaction is an addition reaction between a hydrosilyl group (-SiH) and an aliphatic unsaturated group and is widely used as an important means of synthesizing an organosilicon compound. In particular, in the reaction using an organopolysiloxane, the organopolysiloxane is crosslinked and used as an important reaction in preparing a silicone material. Although the reaction also occurs with light or heat, a radical reaction initiator such as peroxide or a transition metal complex catalyst such as hexachloroplatinum (IV) acid is generally used.

In preparing the silicone material, control of the crosslinking speed is important in terms of processability, workability, etc. Moreover, in order to obtain a material having the desired physical properties, the molecular weight and crosslinking density of the cured product must be appropriately designed. As a method for controlling the crosslinking speed, a method involving including and microencapsulating a catalyst with a thermoplastic resin, etc. is known (Patent Documents 1 and 2). Unfortunately, in the method of microencapsulating the catalyst, although the pot life (preservability) is high, the reaction proceeds instantaneously when heated, making it difficult to control the crosslinking speed itself. On the other hand, the use of two different reaction systems in combination to accelerate the crosslinking rate has been proposed in Patent Documents 3 and 4, but these reaction systems practically require the use of a reaction inhibitor to ensure pot life, and it is difficult to sufficiently and selectively control the curing rate.

On the other hand, organopolysiloxane compositions that cure by irradiation with a high energy beam such as ultraviolet light or the like have recently been used for sealing semiconductor components and sealing/adhering touch panels and other display devices. In particular, the rapid curing properties thereof are expected to be used in precision securing/temporary securing/sealing and the like of members. On the other hand, sealing structures of semiconductor components and touch panels have become more complex in recent years, and there are many areas where it is difficult to irradiate a high energy beam such as ultraviolet light or the like. Thus, the problem of reduced device reliability caused by curing defects in such light shielded portions has become a concern. The present applicant, assuming that it is structurally easy to shield light and difficult to irradiate sufficient ultraviolet light or the like in a resin member that lines a void, such as a gap seal between members configuring a display device, has proposed a composition suitable for optical bonding, having both rapid photocuring properties and curability at low temperatures even in a light shielded region, by using both a first hydrosilylation reaction catalyst that exhibits activity in the composition without irradiation of a high energy beam and a second hydrosilylation reaction catalyst that does not exhibit activity without irradiation with a high energy beam, but that exhibits activity in the composition by irradiation with a high energy beam (Patent Document 5). However, the second hydrosilylation reaction catalyst used herein cannot achieve control of the crosslinking rate because curing proceeds at low temperatures, and in order to ensure the pot life after mixing the curable components, the use of a reaction inhibitor is substantially essential. Furthermore, curing reactivity triggered by irradiation with a high energy beam may also decrease. Therefore, there is a problem where it is inherently difficult to sufficiently and selectively control the curing rate simply by using these catalysts in combination. Therefore, the issues of rapid curing properties, avoidance of curing defects in light shielded portions and ensuring sufficient pot life with a controlled crosslinking rate have not been simultaneously solved, and further improvement is desired. Note that Patent Document 5 does not describe or suggest a method of microencapsulating a catalyst, and since the composition according to the invention is applied to places where heating is inherently difficult, such as under a bezel of a display device or the like, microencapsulated catalysts cannot solve the problems of the invention, such as the problem of curing defects.

### RELATED ART DOCUMENTS

### Patent Documents

Patent Document 1: Japanese Unexamined Patent Application H2-9448
Patent Document 2: Japanese Unexamined Patent Application H2-14244
Patent Document 3: Japanese Unexamined Patent Application 2004-368052
Patent Document 4: Japanese Unexamined Patent Application 2017-110137
Patent Document 5: WO 2019/208756

### SUMMARY OF THE INVENTION

### Problem to be Solved by the Invention

An object of the present invention is to provide: a curable organopolysiloxane composition that exhibits sharp curability during a reaction and rapidly cures while maintaining the pot life of the composition and in which curing defect problems are less likely to occur even in light shielded portions where irradiation with a high energy beam such as ultraviolet light or the like is difficult (inevitably generated by the structure and process); a manufacturing method of a cured product using same; and an application thereof.

### Means for Solving the Problem

The composition of the present invention is a curable organopolysiloxane composition, containing (A) an organopolysiloxane having at least one monovalent hydrocarbon group containing an aliphatic unsaturated bond in a molecule, (B) an organohydrogenpolysiloxane containing at least two hydrogen atoms bonded to a silicon atom in a molecule, (C) a first hydrosilylation catalyst that exhibits activity by irradiating with a high energy beam, and (D) a second hydrosilylation catalyst microencapsulated by a thermoplastic resin with a softening point within a temperature range of 50 to 200°C, and is a composition that uses both a photoactivation hydrosilylation catalyst and a microencapsulated hydrosilylation catalyst, preferably has a low amount of a reactive functional group as component (A), and does not require a reaction inhibitor to ensure pot life. The composition can be used in a method of forming an organopolysiloxane cured product, which includes a curing step (I) involving irradiation with a high energy beam and a curing step (II) by heating, and can be used to manufacture a semiconductor component or display device.

### Effects of the Invention

The composition of the present invention has favorable curing properties, showing sharp and rapid curability during a curing reaction triggered by high energy beam irradiation and heating, while maintaining a favorable pot life, and in which curing defect problems are less likely to occur even in light shielded portions where irradiation with a high energy beam such as ultraviolet light or the like is difficult. Furthermore, the composition of the composition of the present invention can also provide: a semiconductor component or display device with excellent industrial production efficiency and reliability, including an easy-to-control fast curing process triggered by temporary securing of a precision member and irradiation of a high energy beam; and manufacturing methods thereof. Furthermore, since the curing reaction of the composition of the present invention does not proceed until a temperature at which component (D) is activated, the entire composition can be heated and filled to the detail to be assembled for the purpose of ensuring flowability or dispensability (including jet dispensing and the like).

### DESCRIPTION OF THE PREFERRED EMBODIMENT

### (Composition)

The composition of the present invention contains the following components (A) to (D), and preferably the amount of the hydrosilylation reaction inhibitor (E) in the composition is less than 0.1 mass%. The following is a sequential description.

### Component (A)

The composition of the present invention contains an organopolysiloxane (component (A)) containing at least one monovalent hydrocarbon group having an aliphatic unsaturated bond in a molecule. Component (A) is a compound containing an aliphatic unsaturated hydrocarbon group to which a hydrosilylation group (-SiH) is added upon a hydrosilylation reaction. Examples of component (A) include linear or branched organopolysiloxanes having an alkenyl group, which may be optionally used in combination with a polyether containing an alkenyl group, polyolefin containing an alkenyl group, and polyester containing an alkenyl group. Among these, an organopolysiloxane having the following average composition formula (1) is preferable.

R¹ₐR²_{b}SiO_{(4-a-b)/2} (1)

In the average composition formula (1), R¹ represents an alkenyl group with 2 to 12 carbon atoms, with vinyl groups, allyl groups or hexenyl groups being preferred. R² represents a group selected from monovalent hydrocarbon groups having 1 to 12 carbon atoms and not having an aliphatic unsaturated bond, hydroxyl groups, and alkoxy groups, with a methyl group or phenyl group being preferred.

a and b are numbers satisfying the following conditions: 1 ≦ a+b ≦ 3 and 0.001 ≦ a/(a+b) ≦ 0.33. This is because the flexibility of the cured product increases when a+b is 1 or more, while the mechanical strength of the cured product increases when a+b is 3 or less. Moreover, this is because the mechanical strength of the cured product increases when a/(a+b) is 0.001 or more, while the flexibility of the cured product increases when a/(a+b) is 0.33 or less.

Exemplary molecular structures of such an organopolysiloxane include linear, branched, or cyclic structures. The organopolysiloxane may be one compound or a mixture of two or more compounds having such a molecular structure.

Such component (A) is preferably straight chain organopolysiloxane as expressed by the general formula: R⁶₃SiO (R⁶₂SiO)ₘ₁ SiR⁶₃ In the formula, each R⁶ independently represents an unsubstituted or halogen-substituted monovalent hydrocarbon group, at least two of the R⁶ in a molecule are monovalent hydrocarbon groups containing an aliphatic unsaturated bond (preferably, the alkenyl group described above), and the remaining R⁶ is preferably a methyl group or phenyl group. Furthermore, from the perspective of flowability and precision filling, m1 in the formula may be an integer in a range of 5 to 1,000, but the polymer may be a gum-like polymer at room temperature with m1 exceeding 1,000.

In the present invention, component (A) is preferably an organopolysiloxane having a monovalent hydrocarbon group containing two aliphatic unsaturated bonds in one molecule, and a linear organopolysiloxane having monovalent hydrocarbon groups containing aliphatic unsaturated bonds only at both terminals of a molecular chain is particularly preferred. From an industrial perspective, a preferred example is polydimethylsiloxane, which has the aforementioned alkenyl groups only at both terminals of a molecular chain and the degree of polymerization of the dimethylsiloxane units, excluding both terminals, ranges from 5 to 1000, and preferably from 10 to 750, but as described above, some or all of component (A) may be in a gum-like form.

The composition according to the present invention is preferably substantially free of the hydrosilylation reaction inhibitor (E) in the composition from the perspective of achieving sharp reactivity. Therefore, component (A) preferably has a low amount of curing reactive functional groups (particularly, alkenyl groups), as typified by organopolysiloxanes having a monovalent hydrocarbon group containing two aliphatic unsaturated bonds in a molecule as described above, and the amount of CH₂=CH⁻ (vinyl moiety) in component (A) is preferably 1.0 mass% or less, more preferably in a range of 0.05 to 0.75 mass%, and particularly preferably 0.10 to 0.30 mass%. If the amount of CH₂=CH⁻ (vinyl moiety) in component (A) exceeds the aforementioned upper limit, such as by having a large number of alkenyl groups in a molecule and the like, the curability by irradiation with a high energy beam may decrease in the composition according to the present invention.

### Component (B)

The composition of the present invention contains an organohydrogenpolysiloxane containing at least two hydrogen atoms bonded to a silicon atom in a molecule (component (B)). Component (B) is a compound containing a hydrosilylation group (-SiH) which, upon a hydrosilylation reaction, is added to a monovalent hydrocarbon group having an aliphatic unsaturated bond in component (A). Component (B) is preferably an organopolysiloxane having the following average composition formula (2).

H_{c}R³_{d}SiO_{(4-c-d)/2} (2)

In the average composition formula (2), R³ represents a group selected from monovalent hydrocarbon groups having 1 to 12 carbon atoms and not having an aliphatic unsaturated bond, hydroxyl groups, and alkoxy groups, with a methyl group or phenyl group being preferred.

c and d are numbers satisfying the following conditions: 1 ≦ c+d ≦ 3 and 0.01 ≦ c/(c+d) ≦ 0.33, and are preferably numbers satisfying the following conditions: 1.5 ≦ c+d ≦ 2.5 and 0.05 ≦ c/(c+d) ≦ 0.2. This is because the flexibility of the cured product increases when c+d is 1 or more, while the mechanical strength of the cured product increases when c+d is 3 or less. Moreover, this is because the mechanical strength of the cured product increases when c/(c+d) is 1.5 or more, while the flexibility of the cured product increases when c/(c+d) is 0.33 or less.

While not limited thereto, the viscosity of the organopolysiloxane having the average composition formula (2) at 25°C is preferably within a range of 1 to 10,000 mPa·s, and particularly preferably within a range of 1 to 1,000 mPa·s.

Examples of organopolysiloxanes having the average composition formula (2) include 1,1,3-3-tetramethyl disiloxanes, 1,3,5,7-tetramethyl cyclotetrasiloxanes, tris(dimethyl hydrogensiloxy)methylsilanes, tris(dimethyl hydrogensiloxy)phenylsilanes, 1-(3-glycidoxypropyl)-1,3,5,7-tetramethyl cyclotetrasiloxanes, 1,5-di(3-glycidoxypropyl)-1,3,5,7-tetramethyl cyclotetrasiloxanes, 1-(3-glycidoxypropyl)-5-trimethoxysilyl ethyl-1,3,5,7-tetramethyl cyclotetrasiloxanes, methyl hydrogen polysiloxanes blocked with a trimethylsiloxy on both terminals of a molecular chain, dimethyl siloxane/methyl hydrogen siloxane copolymers blocked with a trimethylsiloxy group on both terminals of a molecular chain, dimethyl polysiloxanes blocked with a dimethyl hydrogensiloxy group on both terminals of a molecular chain, dimethyl siloxane/methyl hydrogen siloxane copolymers blocked with a dimethyl hydrogensiloxy group on both terminals of a molecular chain, methyl hydrogen siloxane/diphenyl siloxane copolymers blocked with a trimethyl siloxane group on both terminals of a molecular chain, methyl hydrogen siloxane/diphenyl,siloxane/dimethyl siloxane copolymers blocked with a trimethylsiloxy group on both terminals of a molecular chain, hydrolysis condensates of trimethoxysilane, copolymers containing (CH₃)₂HSiO_{1/2} units and SiO_{4/2} units, copolymers containing (CH₃)₂HSiO_{1/2} units, SiO_{4/2} units, and (C₆H₅)SiO_{3/2} units, and mixtures of two or more types thereof.

Although not particularly limited, the amount of component (B) is an amount in which silicon atom-bonded hydrogen atoms in the present component are within a range of 0.1 to 5 mols, and preferably within a range of 0.5 to 3.0 mols, with respect to a total of 1 mol of monovalent hydrocarbon groups having an aliphatic unsaturated bond in component (A). This is because the mechanical strength of a cured product increases when the content of component (B) is the lower limit of the abovementioned range or more, while the flexibility of the cured product increases when it is the upper limit of the abovementioned range or less. Furthermore, as described earlier, the composition according to the present invention preferably has a smaller amount of monovalent hydrocarbon groups having an aliphatic unsaturated bond in component (A); therefore, if the amount of component (B) is at or below the lower limit of the range above, the pot life of the composition may become insufficient. In particular, by controlling the amount of monovalent hydrocarbon groups having an aliphatic unsaturated bond in component (A) and also controlling the amount of component (B) at or below the upper limit above, side reactions such as hydrogen gas generation and the like in a cured product are controlled even when the curing reaction of the composition proceeds at high speed, and thus a stable and uniform cured product is obtained.

### Component (C)

Component (C) of the present invention is a second hydrosilylation catalyst which does not exhibit activity without irradiating with a high energy beam, but exhibits activity in the present composition by irradiating with a high energy beam and is referred to as a so-called high energy beam activation catalyst or photoactivation catalyst. Note that unlike component (D), component (C) is a catalyst that is not so-called microencapsulated, but due to the properties above, the curing reaction does not proceed unless irradiated with a high energy beam, and thus the pot life of the composition can be maintained.

Herein, examples of high energy beams include ultraviolet light, X-rays, and electron beams, of which ultraviolet light is preferable from the perspective of catalyst activation efficiency. Furthermore, the amount of irradiation varies depending on the type of the high energy beam activation catalyst, but in the case of ultraviolet light, the integrated amount of irradiation at a wavelength of 365 nm is preferably within a range of 100 mJ/cm² to 10 J/cm².

Specific examples of component (C) include (methylcyclopentadienyl) trimethyl platinum (IV), (cyclopentadienyl) trimethyl platinum (IV), (1,2,3,4,5-pentamethyl cyclopentadienyl) trimethyl platinum (IV), (cyclopentadienyl) dimethylethyl platinum (IV), (cyclopentadienyl) dimethylacetyl platinum (IV), (trimethylsilyl cyclopentadienyl) trimethyl platinum (IV), (methoxycarbonyl cyclopentadienyl) trimethyl platinum (IV), (dimethylsilyl cyclopentadienyl) trimethylcyclopentadienyl platinum (IV), trimethyl (acetylacetonato) platinum (IV), trimethyl (3,5-heptanedionate) platinum (IV), trimethyl (methylacetoacetate) platinum (IV), bis(2,4- pentanedionato) platinum (II), bis(2,4-hexanedionato) platinum (II), bis(2,4-heptanedionato) platinum (II), bis(3,5-heptanedionato) platinum (II), bis(1-phenyl-1,3-butanedionato) platinum (II), bis(1,3-diphenyl-1,3-propanedionato) platinum (II), and bis(hexafluoroacetylacetonato) platinum (II). Of these, (methylcyclopentadienyl) trimethyl platinum (IV) and bis(2,4-pentanedionato) platinum (II) are preferred from the perspective of versatility and ease of acquisition.

Although a sharp curing reaction proceeds triggered by irradiation with a high energy beam and fast curing/fast drying can be achieved for portions irradiated by the high energy beam, component (C) has the characteristic in which fast curing/fast drying cannot be achieved and curing proceeds slowly to a deeper level under room temperature for light shielded portions that cannot be sufficiently irradiated with a high energy beam due to the structure thereof (e.g., inside the structure when sealing a semiconductor component or closed portions for display devices). The present invention utilizes component (C) with such properties in combination with component (D) described later in a complementary manner, and preferably without the hydrosilylation reaction inhibitor (E), which allows for a sharp thermosetting reaction in parallel.

The amount is sufficient to improve fast curing/fast drying, and is preferably an amount in which metal atoms in the catalyst are within a range of 1 to 50 ppm by mass units, and preferably within a range of 5 to 30 ppm, with respect to the present composition.

### Component (D)

The composition of the present invention is obtained by microencapsulating a hydrosilylation reaction catalyst with a thermoplastic resin having a softening point within a temperature range of 50 to 200°C. The softening point of the thermoplastic resin is preferably 80°C or higher and 160°C or lower. Exemplary thermoplastic resins include polyolefin resins, polystyrene resins, acrylic resins, cellulose resins, thermoplastic silicone resins, polycarbonate resins, etc. The microencapsulated hydrosilylation catalyst is described in Patent Documents 1 and 2, and can be prepared by the method described therein.

Examples of hydrosilylation catalysts used in component (D) include platinum based catalysts, rhodium based catalysts, palladium based catalysts, nickel based catalysts, iridium based catalysts, ruthenium based catalysts, and iron based catalysts, with platinum based catalysts being preferred. Examples of platinum based catalysts include platinum based compounds, such as platinum fine powders, platinum black, platinum-supporting silica fine powders, platinum-supporting activated carbon, chloroplatinic acids, alcohol solutions of chloroplatinic acids, olefin complexes of platinum, alkenylsiloxane complexes of platinum, and the like. Alkenylsiloxane complexes of platinum are particularly preferable. A platinum-alkenylsiloxane complex using 1,3-divinyl-1,1,3,3-tetramethyldisiloxane is particularly preferable due to the favorable stability of the platinum-alkenylsiloxane complex.

Component (D) exhibits catalytic activity as the catalyst is released/diffused at temperatures above the softening point of the thermoplastic resin used for microencapsulation. Thus, the temperature at which catalytic activity is exhibited varies depending on the type of thermoplastic resin, but is typically 80°C or more, preferably 100°C or more, and further preferably 120°C or more.

Component (D), in combination with component (C), allows the catalyst to respond to heating at or above aforementioned temperature to achieve a rapid and complete effect, even on light shielded portions where the structure does not allow sufficient irradiation of high energy beams. Furthermore, since component (D) basically does not function as a catalyst below the softening point of thermoplastic resin, the curing reaction originating from component (D) does not proceed even after irradiation with a high energy beam. Therefore, the present composition has both sharp curing properties triggered by high energy beam irradiation and sharp curing properties triggered by heating above a certain temperature, but in the absence of each trigger, the curing reaction does not proceed, and favorable pot life can be maintained because the catalyst is in a deactivated state. Therefore, the hydrosilylation reaction inhibitor (E) is not necessary, and fast curing properties can be achieved without being hindered by the inhibitor.

If other hydrosilylation reaction catalysts (e.g., those disclosed in Patent Document 5) are used, such sharp curing properties cannot be achieved, and if a hydrosilylation reaction inhibitor is lacking, a practical pot life cannot be ensured. Therefore, the problems of the present invention cannot be solved.

The amount of component (D) is the amount required for curing and is preferably an amount in which metal atoms in the catalyst are within a range of 0.1 to 50 ppm by weight units, preferably within a range of 0.5 to 30 ppm, and more preferably within a range of 1 to 10 ppm with respect to the present composition. As an example, when component (B) is an organohydrogenpolysiloxane represented by the general formula (3), the content of component (D) is an amount capable of sufficiently hydrosilylating the DH unit in the organohydrogenpolysiloxane.

The molar ratio ((C)/ (D)) of the amount of platinum metal in components (C) and (D) is typically within a range of 0.01 to 200, and preferably 0.1 to 100. This is because the curing reaction can be accelerated at high temperatures when the molar ratio is the abovementioned upper limit or less, while the curing reaction can be carried out at low temperatures in a short period of time when the molar ratio is the abovementioned lower limit or more. Note that of components (C) and (D), it is preferable to use relatively more of component (C) when fast curing by high energy beam irradiation is important.

The present composition preferably does not contain the hydrosilylation reaction inhibitor (E). Normally, for a curable composition that cures by a hydrosilylation reaction, it is essential for practical purposes that a hydrosilylation reaction inhibitor be added to the composition after all curable components are mixed or into single component compositions, in order to improve pot life and obtain a stable composition. However, hydrosilylation reaction inhibitors inhibit the reaction even when the catalyst is activated by irradiation with a high energy beam or heating, thereby preventing sharp curing properties. Furthermore, as described above, in the present composition, components (C) and (D) are inactive as catalysts until the respective triggering stimuli are provided, and the amount of curing reactive functional groups in component (A) is preferably suppressed, such that the pot life is sufficient for practical use even without using the hydrosilylation reaction inhibitor. Specifically, the present composition is particularly preferred if the amount of the hydrosilylation reaction inhibitor (E) is less than 0.1 mass%, less than 0.01 mass%, or less than the detection limit.

In particular, in the present invention, it is preferable that the components whose blending is considered essential from the perspective of product design, handling workability, and practical use are not required or the blending amount thereof is less than the lower limit above, in a curable composition that cures by a normal hydrosilylation reaction, such as 3-methyl-1-butyn-3-ol, 3,5-dimethyl-1-hexyn-3-ol, 3-phenyl-1-butyn-3-ol, 1-ethynyl-1-cyclohexanol, and other acetylenic compounds; 3-methyl-3-penten-1-yne, 3,5-dimethyl-3-hexene-1-yne, and other enyne compounds; 1,3,5,7-tetramethyl-1,3,5,7-tetravinylcyclotetrasiloxane, 1,3,5,7-tetramethyl-1,3,5,7-tetrahexenylcyclotetrasiloxane, and other cycloalkenylsiloxanes; hydroxyl-terminated or modified methylvinylsiloxane oligomers and hydroxyl-terminated or modified methylvinyl-dimethylsiloxane oligomers; benzotriazole and other triazole compounds; and the like. The inclusion of these hydrosilylation reaction inhibitors may interfere with the sharp curing properties that characterize the present invention, because even without them, the composition according to the present invention has sufficient usable life and pot life, and a single component composition design is possible.

The present composition may contain other organopolysiloxanes, an adhesion imparting agent, an inorganic filler such as silica, glass, alumina, and zinc oxide, an organic resin fine powder such as a polymethacrylate resin, a phosphor, a heat resistant agent, a dye, a pigment, a flame retarder, a solvent, etc. An inorganic filler is added to increase the amount of the composition, reinforce the physical strength, or add functions such as conductivity and thermal conductivity.

### [Preparation and Form of Single Component/Multi-Component Composition]

The composition according to the present invention can be manufactured by uniformly mixing the components (A) to (D) above and, if necessary, another optional component at room temperature by mechanical power such as a mixer or the like. Particularly preferably, the present composition is preferably a one-component (= single component) composition, or a two-component (= double component) or more multi-component composition, having at least hydrosilylation reaction curing properties. However, even if the present composition is a one-component (= single component), the composition can be stored over a long period of time by sealing in a sealed container at room temperature without using the hydrosilylation reaction inhibitor (E), and has sufficient usable life and pot life for practical use.

### [Application Method; Precision and Fine Coating Properties]

The composition according to the present invention can be applied using known coating or injection methods for adhesion between members, to the interior of a device, or to minute irregularities or narrow gap structures, and can be cured by a curing method described later. In particular, since the composition according to the present invention is applied between or inside members that contain light shielded portions, coating or injection is preferred, and thus the composition can easily be applied to coating/injection in precise, fine, and small quantities. Examples of dispensers include air, valve, screw, volumetric, and jet dispensers. Furthermore, as described above, since the catalyst is not activated by heating below the melting point or glass transition temperature of the thermoplastic resin serving as a wall material of component (D), the composition according to the present invention can be applied heated in the temperature range where component (D) is not activated in order to ensure flowability, thereby improving flowability or fine filling properties and coating properties. For example, even if the flowability is insufficient at room temperature, heating can be performed to improve flowability to achieve fine or precision coating properties, or to fill the inside of a device, minute irregularities or narrow gap structures without gaps.

### (Method of Forming Cured Product)

Another form of the present invention is a method for forming a cured product by a hydrosilylation reaction having the following steps of:
(i) a step of irradiating a high energy beam on the curable organopolysiloxane composition to cause a first hydrosilylation reaction to proceed to obtain a semi-cured product or cured product; and
(ii) a step of heating the obtained semi-cured product at a temperature at which component (D) exhibits activity and to cause a second hydrosilylation reaction to proceed to obtain a cured product.

### (Step (i))

Step (i) is a step in which only component (C) is activated by irradiating the composition with a high energy beam, such that a first hydrosilylation reaction proceeds to achieve a rapid curing reaction.

The timing and amount of irradiation of the high energy beam in the composition of the present invention are arbitrary, and it goes without saying that the composition may be irradiated with a high energy beam at the time of actual use, immediately after preparation, or after a certain period of time with supplementary irradiation. Note that the practical irradiation amount and the irradiation amount for defining the aforementioned properties are as described above, but are not limited thereto in actual use.

In the present invention, the composition is designed with the assumption that there are light shielded portions of a structure that cannot be sufficiently irradiated with a high energy beam, such as inside the structure in the encapsulation of a semiconductor component, sealed portions for display devices, and the like. Therefore, even if the aforementioned step (i) is performed in the presence of a shield or structure that prevents irradiation of high energy beams for at least a portion of the curable organopolysiloxane composition, curability in the light shielded portion, which is a technical effect of the present invention, can be ultimately realized. On the other hand, in order to achieve fast curing, the curing reaction in step (i) may and is preferably accelerated by irradiating a high energy beam using a light source, such as a spot UV light source, that produces as little light shielded portions as possible.

### (Step (ii))

Step (ii) is a step in which the composition with component (C) activated is preferably further heated to a temperature at which the component (D) shows activity, and a second hydrosilylation reaction is performed to obtain a cured product. Preferably, the heating temperature in step (ii) is preferably higher than the melting temperature or glass transition temperature of the thermoplastic resin serving as a wall material of a capsule, specifically, 80°C or higher, 100°C or higher, or 120°C or higher. At the same time, in some cases, the heating temperature is 200°C or less, or 180°C or less, or 160°C or less. The heating time depends on the type and formulation amount of each component in the composition, as well as the heating temperature, but is typically one minute to 10 hours, preferably five minutes to two hours.

With step (ii), the curable organopolysiloxane composition in the light shielded portion, where sufficient curing reactions could not proceed only by step (i) above, can be quickly and completely cured and used as various materials.

Steps (i) and (ii) above may be performed simultaneously in time or separately. However, if step (ii) is performed first, the entire body is heat cured, and the curing reactivity triggered by the high energy beam irradiation according to step (i) may not be utilized.

[Method of Manufacturing Semiconductor Component or Display Device]

A manufacturing method including the method of forming the organopolysiloxane cured product described above can provide a method of manufacturing a semiconductor component or display device. The manufacturing method or process can be selected/designed as appropriate. For example, by injecting the curable organopolysiloxane composition according to the present invention into a gap between members or inside the structure and irradiating with a high energy beam, a curing reaction derived from the component (C) described above can be quickly progressed in portions where light can be irradiated, preventing misalignment of members to be assembled/secured/sealed and enabling rapid temporary securing, including precise positioning and the like. Furthermore, since the present composition has heat curability and sharp curing properties, after the aforementioned temporary securing or at the same time, the entire composition is heated to advance the curing reaction derived from the aforementioned component (D). The curing reaction is advanced for light shielded portions (internal structures, inside of gaps, and the like), which are difficult to irradiate with a high energy beam, to enable precise securing and positioning of a semiconductor component or display device, and can be used in manufacturing methods such as sealing, adhering, gap sealing, and the like between members.

Furthermore, the aforementioned organopolysiloxane cured product may be used in manufacturing methods of sealing, adhering, gap sealing, and the like of a semiconductor component or display device by irradiating with a high energy beam in advance, then injecting the curable organopolysiloxane composition according to the present invention into a void (gap) between members or inside a structure of a semiconductor component or display device, and quickly advancing a curing reaction deriving the component (C) above or simultaneously heating the composition to advance a curing reaction derived from component (D) above. Furthermore, the irradiation of a high energy beam may be performed at both pre-/post-injection times.

### Embodiments

Cured products were obtained from compositions containing the following components by the parts number listed in Table 1. Note that in each average composition formula, Me and Vi represent a methyl group and a vinyl group, respectively. The following compounds or compositions were used as raw materials in the following experimental examples (embodiments, reference examples, and comparative examples). Furthermore, the SiH/Vi ratio for each composition is entered in Table 1.

### <Components of the curable organopolysiloxane composition>

A1: Linear polydimethylsiloxane blocked with dimethylvinyl groups at both terminals, having a viscosity of 400 mPa·s at 20°C (amount of vinyl groups = 0.44 mass%)
A2: Linear polydimethylsiloxane blocked with dimethylvinyl groups at both terminals, having a viscosity of 2000 mPa·s at 20°C (amount of vinyl groups = 0.23 mass%)
A3: a masterbatch with 80 mass% of component A2 and 20 mass% of silazane treatment dry silica described above (having an average primary particle diameter of 0.1 to 0.2 µm as measured by a laser diffraction/scattering method) B1: a methylhydrogensiloxane/dimethylsiloxane copolymer blocked with trimethylsiloxy groups at both terminals of a molecular chain, having a viscosity of 60 mPa·s at 20°C (content of silicon atom-bonded hydrogen atoms = 0.7 mass%)
B2: Dimethylsiloxane blocked with dimethylhydrogensiloxy groups at both terminals of a molecular chain having a viscosity of 30 mPa·s at 20°C (amount of silicon atom-bonded hydrogen atoms = 0.13 mass%)
C1: (Methylcyclopentadienyl) trimethylplatinum (IV) complex (curing reaction catalyst that causes a hydrosilylation reaction to proceed by ultraviolet (UV) irradiation)
D1: Platinum-1,3-divinyl-1,1,3,3-tetramethyldisiloxane complex dispersed in polycarbonate particles with an average particle diameter of 2 micrometers and 4000 ppm as platinum atoms
D': Platinum-1,3-divinyl-1,1,3,3-tetramethyldisiloxane complex
   (not encapsulated)
E1: 1,3,5,7-tetramethyl-1,3,5,7-tetravinyl-cyclotetrasiloxane
E2: Ethynylcyclohexanol
F1: Adhesion-imparting agent expressed by the following structural formula (where Me represents a methyl group) 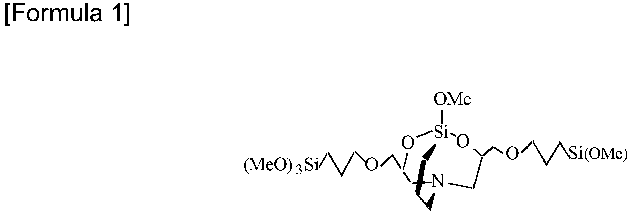
F2: Condensation reaction product of 3-glycidoxypropyl trimethoxysilane and a methylvinylsiloxane oligomer blocked with hydroxyl groups at both terminals of a molecular chain, having a viscosity of 30 mPa·s at a mass ratio of 1:1

Each composition was evaluated using the following methods. The evaluation results are shown in Table 1. All evaluation items were OK only for the compositions according to the embodiments.

### [UV Fast Curability]

0.1 mL of the liquid compositions of each experimental example was placed on an aluminum plate and irradiated with ultraviolet (UV) light from the following UV light source from a height (distance) of 15 mm.
Light source: UV LED spot light: ULEDN-101 (NS-Lighting Co. Ltd.) Wavelength: 365 nm
Amount of irradiation: UV energy: 3000 mW/cm² as maximum 30 seconds after the start of UV light irradiation, the surface of the composition after UV irradiation was immediately touched with tweezers, and if liquid sticks, it is not cured and is rated "NG"; if not, it is fully cured and is rated "OK".

### [Curability of Light Shielded Portion]

Liquid compositions of each experimental example were applied on a SUS316 plate that is 10 mm wide, 50 mm long, and 0.2 mm thick, and then thermally cured (without UV irradiation) in a circulating oven (130°C, 1 hour) with the plate covered by aluminum foil and shielded from light. The surface of the composition after curing was touched with tweezers, and if liquid adheres, the sample is not cured and is rated "NG"; otherwise, the sample is fully cured and is rated "OK".

### [Pot Life]

The liquid composition of each experimental case was placed in a 2.5 cc syringe, and after 24 hours of storage at a temperature of 25°C and 50% humidity, the composition was evaluated to determine if it could be ejected from the syringe by the same force as before storage. (Evaluation criteria: OK: liquid and can be ejected without problems; NG: hardened or thickened and cannot be ejected)

**[Table 1]**

| | **Embodiments** | **Reference Examples** | **Comparative Example 1** | **Comparative Example 2** | **Comparative Example 3** | **Comparative Example 4** |
|---|---|---|---|---|---|---|
| A-1 | | | 94.13 | 94.13 | 94.13 | 89.08 |
| A-2 | 77.45 | 76.10 | | | | |
| A-3 | 20.00 | 20.00 | | | | |
| B-1 | 1.86 | 2.81 | 3.1 | 3.1 | 3.1 | 1.75 |
| B-2 | | | 2.2 | 2.2 | 2.2 | 8.5 |
| C | 0.17 | 0.17 | 0.17 | 0.17 | 0.17 | 0.17 |
| D-1 | 0.12 | 0.12 | | | | |
| D-2 | | | | 0.2 | 0.2 | |
| F-1 | 0.4 | 0.4 | 0.4 | 0.4 | 0.4 | |
| F-2 | | | | | | 0.5 |
| E-1 | | 0.4 | | | | |
| E-2 | | | | | 0.2 | |
| | 100 | 100 | 100 | 100 | 100 | 100 |
| SiH/Vi ratio | 1.50 | 1.50 | 1.51 | 1.26 | 1.24 | 1.47 |
| Fast UV cure | | | | | | |
| **UV Fast Curability** | OK | NG | OK | OK | NG | NG |
| | | | | NG | | |
| Shadow cure | | | | **Generation of numerous hydrogen bubbles** | | |
| **Curability of Light Shielded Portion** | OK | OK | NG | | OK | NG |
| Pot life | OK | OK | OK | NG | OK | OK |
| **Pot life** | | | | | | |

### Industrial Applicability

The present compositions are useful as various potting agents, sealants, adhesives, and pressure sensitive adhesives. In particular, the present composition has excellent curability and has sharp curing properties including in light shielded portions during reactions while maintaining favorable pot life even when exposed to high temperature and high humidity, and also allows fine and precise coating and precise positioning or temporary securing using a rapid photocuring reaction as needed. Therefore, the present composition is useful as a sealing material, adhesive or pressure sensitive adhesive for semiconductor devices with complex internal structures, optical displays and other display devices (including touch panels) as well as optical semiconductor devices (including Micro LEDs). Furthermore, the present composition is not limited to semiconductor devices, optical displays, and the like, and can be used without limitation for adhering or filling a member. For example, the present composition can be used in solar cells, multilayer glass (smart glass), optical waveguides, projector lens (multilayer lens, polarizing/optical film adhering) and other sealing layers, adhesive layers, and the like.

## Claims

1. A curable organopolysiloxane composition, comprising the following components:
(A) an organopolysiloxane having at least one monovalent hydrocarbon group containing an aliphatic unsaturated bond in a molecule;
(B) an organohydrogenpolysiloxane containing at least two hydrogen atoms bonded to a silicon atom in a molecule;
(C) a first hydrosilylation catalyst that exhibits activity by irradiating with a high energy beam; and
(D) a second hydrosilylation catalyst microencapsulated by a thermoplastic resin with a softening point within a temperature range of 50 to 200°C.

2. The curable organopolysiloxane composition according to claim 1, wherein component (A) is an organopolysiloxane having a monovalent hydrocarbon group containing two aliphatic unsaturated bonds in a molecule.

3. The curable organopolysiloxane composition according to claim 1 or 2, wherein component (A) is a linear organopolysiloxane having a monovalent hydrocarbon group containing aliphatic unsaturated bonds only at both molecular terminals.

4. The curable organopolysiloxane composition according to any one of claims 1 to 3, wherein the amount of hydrogen atoms bonded to a silicon atom in component (B) is within a range of 0.5 to 3.0 mols with respect to 1 mol of aliphatic unsaturated bonds in component (A), and the amount of hydrosilylation reaction inhibitors (E) in the composition is less than 0.1 mass%.

5. The curable organopolysiloxane composition according to any one of claims 1 to 4, wherein component (C) and component (D) both contain a platinum-based metal, and the molar ratio of platinum-based metals of both components ((C)/(D)) is within a range of 0.1 to 100.0.

6. The curable organopolysiloxane composition according to any one of claims 1 to 5, which is a single component composition.

7. A method of forming an organopolysiloxane cured product, comprising the following steps:
(i) a step of irradiating a high energy beam on the curable organopolysiloxane composition according to any one of claims 1 to 6 to cause a first hydrosilylation reaction to proceed to obtain a semi-cured product or cured product; and
(ii) a step of heating the obtained semi-cured product at a temperature at which component (D) exhibits activity to cause a second hydrosilylation reaction to proceed in order to obtain a cured product.

8. The method of forming an organopolysiloxane cured product according to claim 7, wherein the aforementioned step (i) is performed in the presence of a shield or structure that prevents irradiation of high energy beams for at least a portion of the curable organopolysiloxane composition, and
in the aforementioned step (ii), the curable organopolysiloxane composition, for which the curing reaction did not sufficiently proceed in step (i) alone, is completely cured.

9. The method of forming the organopolysiloxane cured product according to claim 7 or 8, wherein the aforementioned step (i) and step (ii) are performed simultaneously.

10. The method of forming the organopolysiloxane cured product according to claim 7 or 8, wherein the aforementioned step (i) and step (ii) are performed at separate times.

11. A method of manufacturing a semiconductor component or display device, comprising the method of forming an organopolysiloxane cured product according to any one of claims 7 to 10.

12. An organopolysiloxane cured product obtained by curing the curable organopolysiloxane composition according to any one of claims 1 to 6.

13. A semiconductor component or display device, comprising the organopolysiloxane cured product according to claim 12.
